# EUROPÄISCHE PATENTANMELDUNG

(11) **EP 0 608 700 A1**
(43) Veröffentlichungstag der Anmeldung: **03.08.1994**
(21) Anmeldenummer: 94100325.3
(22) Anmeldetag: 12.01.1994
(51) Int. Cl.: C23G 5/04, B01D 61/14, H05K 3/26, H01L 21/00

(54) **Verfahren zur Wiedergewinnung einer in einem Spülbad gelösten Flüssigkeit**

(30) Priorität: 27.01.1993 DE 4302115; 15.03.1993 DE 4309096
(71) Anmelder: DR. O.K. WACK GmbH, D-85053 Ingolstadt (DE)
(72) Erfinder: Wack, Oskar K., Dr., D-85053 Ingolstadt (DE); Hanek, Martin, Dr., D-85053 Ingolstadt (DE)
(74) Vertreter: Le Vrang, Klaus

(57) **Zusammenfassung**

Es wird ein Verfahren vorgeschlagen, um Gegenstände in einem nichtwäßrigen, organischen Lösungsmittel zu reinigen. Die in dem Lösungsmittel in Lösung übergegangenen Schmutzanteile werden durch Mikrofiltration entfernt. Aus dem anschließenden Spülbad werden die verschleppten Reinigungsmittelrückstände zurückgewonnen und in das Reinigungsbad zurückgeführt. Damit entsteht ein in sich geschlossener Kreislauf, der eine ökologisch sehr geringe Belastung mit sich bringt.

## Beschreibung

Die Erfindung betrifft ein Verfahren zur Wiedergewinnung einer in einem Spülbad gelösten Flüssigkeit gemäß Oberbegriff des Anspruchs 1.

Ein Verfahren dieser Art ist in der DE-A 1 621 648 beschrieben. Dort wird vorgeschlagen, bei einem Zweibadverfahren, in dessen erstem Bad wäßrige Metallbehandlungsprozesse vorgenommen werden, die Produkte in einem zweiten Spülbad abzuwaschen, wobei das Spülbad in einem Kreislauf verdampft wird. Die dabei zurückgewonnenen Anteile aus dem ersten Bad werden in dieses durch Zurückpumpen eingeleitet.

In der nicht vorveröffentlichten europäischen Patentanmeldung 92113503 wird ein Bad beschrieben, bestehend aus Glykoläthern, das zur Reinigung von Leiterplatinen dient, die von Lötmitteln und/oder Flußmittelrückständen zu befreien sind. In dem Glykolätherbad, dessen Reinigungswirkung mit Ultraschall verstärkt werden kann, werden die Leiterplatinen eingetaucht. Das Bad wird auf einer Temperatur von ca. 40° bis 50°C gehalten.

Nach der Reinigung werden die Platinen in einen zweiten Behälter eingetaucht, in dem sie mit Spülwasser von den Glykoläthern befreit werden. Durch die Verschleppung von Glykoläthern in das Wasserbad im zweiten Behälter steigt die Konzentration der Glykoläther in dem zweiten Behälter allmählich an. zugleich verschmutzt das Reinigungsbad durch die gelösten Schmutzanteile, die aufgrund der Verwendung eines nichtwäßrigen organischen Reinigungsmittels in vollständige Lösung übergehen.

Die Platinen können nach dem Spülvorgang in dem zweiten Behälter in einen dritten Wasserbehälter zur weiteren Reinigung eingebracht werden und anschließend im Luftstrom, vorzugsweise im geheizten Luftstrom, getrocknet werden.

Bei einer einfachen Rückführung der verschleppten Anteile aus dem Spülbad in das erste Bad wird aber wiederum das erste Bad durch zwangsläufig in dem Rückführungsstrom enthaltene Spülflüssigkeitsanteile belastet.

Aufgabe der Erfindung ist es, die Belastung des Reinigungsbades durch Verunreinigungen und/oder gelöste Anteile möglichst gering zu halten.

Die Aufgabe wird gelöst durch Anspruch 1.

Erfindungsgemäß ist zur Reinhaltung des Reinigungsbades dort ein zweiter Kreislauf vorgesehen, der das darin enthaltene Reinigungsmittel an einer semipermeablen Membran vorbeiführt. Durch die unterschiedlichen Durchlässigkeiten der Membran für das Reinigungsmittel des ersten Bades und Verunreinigungen, die in gelöster Form in dem Reinigungsbad enthalten sind, gelingt es durch Mikrofiltration, die Reinigungsflüssigkeit von bei der Rückführung verschleppter Spülflüssigkeit und von gelösten Schmutzinhalten zu trennen.

In einer bevorzugten Ausgestaltung der Erfindung ist vorgesehen, daß die rückzuführende Reinigungsflüssigkeit nicht nach dem Vorbild des Standes der Technik einfach in das erste Bad eingebracht wird. Vielmehr geschieht die Rückführung von dem zweiten Bad in das erste Bad genau in diesen zweiten Umwälzkreislauf des ersten Bades, und zwar stromaufwärts der Membran. Dadurch wird, noch bevor die mitgerissene Spülflüssigkeit aus dem zweiten Bad, die in gewissen Anteilen dem zurückzuführenden Reinigungsmittel beigemengt ist, genau an der Stelle eingebracht, wo sie wieder abgeschieden wird, sie gelangt also nicht bis in das erste Bad.

In weiteren Unteransprüchen sind bevorzugte Ausgestaltungen des erfindungsgemäßen Verfahrens beschrieben, in denen in vorteilhafter Weise ein Synergieeffekt erzielt wird.

So ist ein dritter Kreislauf der Spülflüssigkeit in dem zweiten Behälter vorgesehen, in dem zur Verbesserung der Spülwirkung die Spülflüssigkeit mit hoher Strömungsgeschwindigkeit umgewälzt wird. In diesen Kreislauf wird eine Wasserstrahlpumpe eingebracht, die somit zugleich zur Erzielung des Unterdrucks in dem Verdampfer, der dazu vorteilhafterweise als Vakuumverdampfer ausgebildet ist, eingesetzt wird. Dementsprechend wird der Unterdruck des Vakuumverdampfers ohne zusätzliche Energiezufuhr, sozusagen als Abfallprodukt der ohnehin vorhandenen Ressourcen, erzeugt.

Ein Nebeneffekt in dieser Version ist, daß durch die von der Wasserstrahlpumpe aus dem Vakuumverdampfer abgesaugte Luft die Turbulenzen in der Spülflüssigkeit vergrößert werden und somit die Spülwirkung weiter verbessert wird.

In einer weiteren Ausgestaltung läßt sich die Wirkung des Vakuumverdampfers dadurch erhöhen, daß zugleich Wärme zugeführt wird.

Vorteilhafterweise ist im ersten Behälter ein Ultraschallgeber eingesetzt, der die Reinigungswirkung der in diesem Behälter befindlichen Flüssigkeit verstärkt. Der Betrieb des Ultraschallgebers führt zugleich zu einer Erwärmung der Flüssigkeit in dem ersten Behälter, und die dabei anfallende Abwärme kann zur Unterstützung der Verdampfungsgeschwindigkeit in dem Vakuumverdampfer verwendet werden. Somit kann im Idealfall die ohnehin dem Gesamtsystem zugeführte Energie dazu eingesetzt werden, die Abtrennung der Flüssigkeit aus dem Spülbad zu erzielen.

Zur Entfernung von Rückständen in fester Form kann die Reinigung der Flüssigkeit in dem ersten Behälter dadurch durchgeführt werden, daß in dem zweiten Kreislauf die Flüssigkeit des ersten Behälters über eine weitere Membran geführt wird, die vorteilhafterweise stromaufwärts der ersten Membran angeordnet ist. Die Rückstände in der Flüssigkeit des ersten Behälters können diese zweite Membran nicht passieren und sammeln sich vor ihr, wo sie abgeführt werden. Da die Öffnung der Rückführung von dem zweiten Bad, dem Spülbad, zum ersten Bad, dem Reinigungsbad, stromaufwärts der ersten Membran erfolgt, passiert die wieder eingebrachte Flüssigkeit, bevor sie endgültig in das Reinigungsbad wieder eintritt, auch erst die zweite Membran und wird dort ebenfalls gereinigt.

Als Membran hat sich dabei eine Keramikmembran als geeignet erwiesen.

Um den Aufwand der Rückgewinnung zu verringern, ist es vorteilhaft, in dem zweiten Behälter statt eines Bades mit größeren Mengen an Spülflüssigkeit eine Sprüheinrichtung vorzusehen, mit Hilfe derer die Flüssigkeit aus dem ersten Bad abgespült wird. Der Trennungsaufwand wird dadurch deutlich verringert, da sehr viel geringere Mengen der Vakuumverdampfung unterworfen werden müssen.

Eine praktische Verwendung der Erfindung ist die eingangs beschriebene Säuberung von Leiterplatten in einem Gemisch aus Glykoläthern, wobei nachgeschaltet in Spülbädern die Glykoläther wieder von den Leiterplatten entfernt werden.

Im folgenden wird die Erfindung anhand der Zeichnung erläutert. Es zeigen:
- Fig. 1: eine erste Anlage für das erfindungsgemäße Verfahren,
- Fig. 2: eine zweite Ausgestaltung der Anlage, und

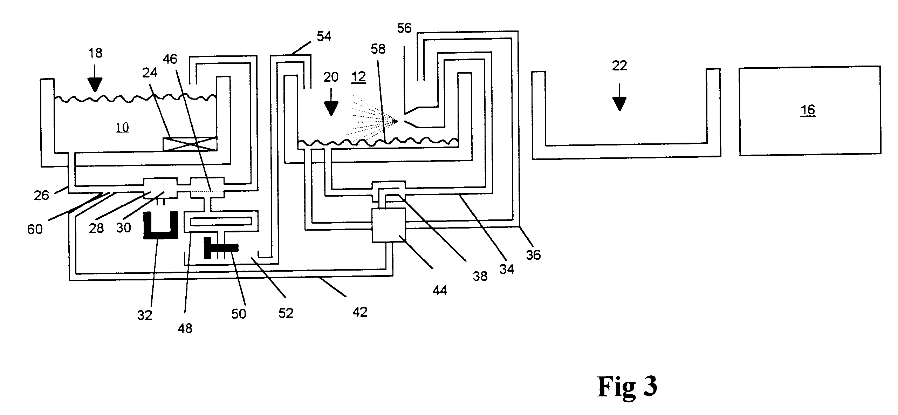

- Fig. 3: eine weitere Alternative der Anlage.

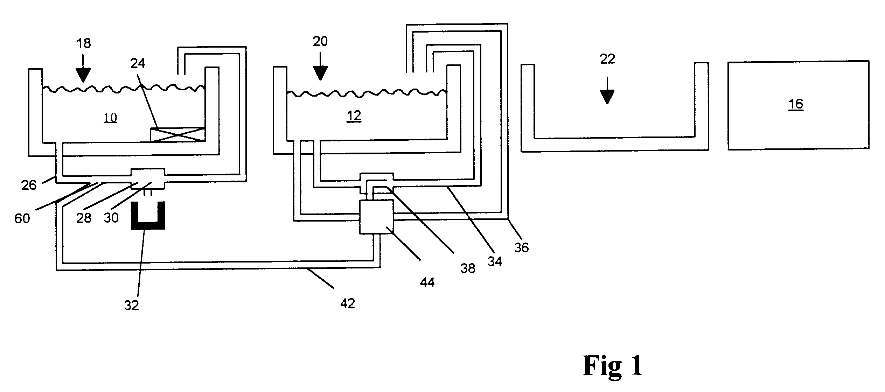

In Figur 1 ist ein erster Behälter 18 dargestellt, in dem sich eine Reinigungsflüssigkeit 10 befindet. Dabei handelt es sich bei dem geschilderten Anwendungsfall um ein nichtwäßriges Glykoläthergemisch, das je nach Zusammensetzung einen Siedepunkt von mindestens 120 °C, gegebenenfalls bis ca. 220 °C aufweist. Zu reinigende Gegenstände können Leiterplatinen sein, die nach der Montage von Halbleitern und elektronischen Bauteilen verlötet wurden und jetzt von den Lötmitteln und Flußmittelrückständen zu befreien sind. Andere Anwendungsgebiete sind mechanische oder optische Teile, die in dem Bad 10 im Behälter 18 entfettet werden. Bei dem Verbleib der zu reinigenden Gegenstände in diesem Reinigungsbad gehen die Verschmutzungen wie Flußmittel und Lötrückstände in Lösung über, sind also nicht als Schwebestoffe oder Suspension in dem Glykoläthergemisch enthalten. dementsprechend problematisch ist die Reinigung des Glykoläthergemisches von diesen eingeschleppten Verunreinigungen.

Ein Ultraschallgeber 24 ist dargestellt, er dient der Unterstützung der Reinigungswirkung. Sein Betrieb führt, wie weiter unten noch zu erläutern ist, aufgrund der zugeführten und von ihm wieder abgestrahlten Energie zu einer Erwärmung des Bades 10.

Nach der Reinigung der im Bad 10 für eine gewisse Zeit verbliebenen Gegenstände werden diese in den Behälter 20 überführt, in dem sich ein Spülbad 12 befindet. Im vorliegenden Falle handelt es sich dabei um Wasser. Im Laufe des Betriebes werden Glykoläther mit den herausgenommenen Gegenständen in das Bad 12 im Behälter 20 verschleppt. Aus diesem Grunde ist ein dritter Behälter 22 vorgesehen, der ebenfalls ein Spülbad 14 enthält, hier wieder aus Wasser. Da dieser Teil der Anlage, ebenso wie die Trocknungsstation 16 für die Erläuterung der vorliegenden Erfindung ohne Bedeutung ist, ist auf eine detaillierte Darstellung der Wirkungsweise dieses Teiles verzichtet worden, es wird verwiesen auf die nicht vorveröffentlichte europäische Patentanmeldung 92 113 503, in der ein derartiger Aufbau dargestellt ist, insbesondere die Rückgewinnung von Reinigungsflüssigkeit über Adsorberharze beschrieben ist.

Dem Behälter 18 mit der Reinigungsflüssigkeit 10 ist ein Kreislauf 26 zugeordnet, mit Hilfe dessen die Reinigungsflüssigkeit umgewälzt und über eine Keramikmembran 30 in einer Mikrofiltrationskammer 28 geführt wird. Die Reinigungsflüssigkeit 10 kann die Keramikmembran, die eine Porenweite zwischen 0,001 und 10 µm, vorzugsweise 0,02 µm besitzt, passieren, die Verunreinigungen werden somit abgetrennt und, wie schematisch dargestellt, in einem Behälter 32 aufgefangen und entsorgt.

Auch dem Behälter 20 mit der Spülflüssigkeit 12 sind Kreisläufe zugeordnet, ein Kreislauf 34 dient der Umwälzung der Spülflüssigkeit, wodurch die Reinigungswirkung verbessert wird und Konzentrationen der verschleppten Reinigungsflüssigkeit vermieden werden. Dazu ist eine hier nicht dargestellte Pumpe dem Kreislauf zugeordnet, die für einen Durchsatz im vorliegenden Falle von etwa 50 l/min sorgt. Damit kann der Inhalt des Behälters 12, der etwa 50 l beträgt, einmal pro Minute umgewälzt werden.

Ein weiterer Kreislauf 36 ist vorgesehen, der der Rückgewinnung der verschleppten Reinigungsflüssigkeit dient. Dazu wird in diesem Kreislauf der Inhalt des Bades 12 durch einen Vakuumverdampfer 44 geleitet. In diesem Verdampfer 44 wird ein Unterdruck von etwa 200 mbar eingestellt, der durch eine Wasserstrahlpumpe 38, die durch den Kreislauf 34 betrieben wird, erzeugt wird. Da die Siedepunkte der Glykoläther je nach Zusammensetzung im Bereich zwischen 120 °C und 220 °C liegen, lassen sich die Glykoläther von dem Wasser trennen. Das Wasser wird als Dampf, der wieder kondensiert, zurückgeführt in den Behälter 20, die Glykoläther werden über eine Leitung 42 in den Behälter 18 gebracht.

Diese Leitung 42 mündet in den Kreislauf 26 des ersten Behälters 18, und zwar in eine Stelle 60, die stromauf der Keramikmembran 30 liegt. Auf diese Weise ist sichergestellt, daß der in den Behälter 20 gelangte Schmutz, der bei der Verdampfung des Wassers im Vakuumverdampfer ebenso wie die Glykoläther zurückbleibt und mit diesen wieder zurückgeführt wird in den Behälter 18, nicht in das Bad 10 gelangt, sondern vorher bereits die Keramikmembran 30 in der Mikrofilterstation 28 wirksam wird und auch diesen Schmutz aussondert.

Falls der Unterdruck in dem Vakuumverdampfer allein nicht ausreichend ist, um die beabsichtigte Trennung zu erzeugen, ist noch Wärmezufuhr zumindest erwünscht. Das Bad 10 stellt sich auf einer Temperatur von ca. 40 bis 50 °C ein, die für die Reinigungswirkung optimal ist. Durch die Ultraschallerzeugung in dem Geber 24 jedoch wird weitere Energie hinzugeführt. Diese kann, beispielsweise durch einen Wärmetauscher, wieder abgegeben werden und dient zur Erwärmung des Gemisches im Kreislauf 36, so daß die Verdampfungswirkung unterstützt wird.

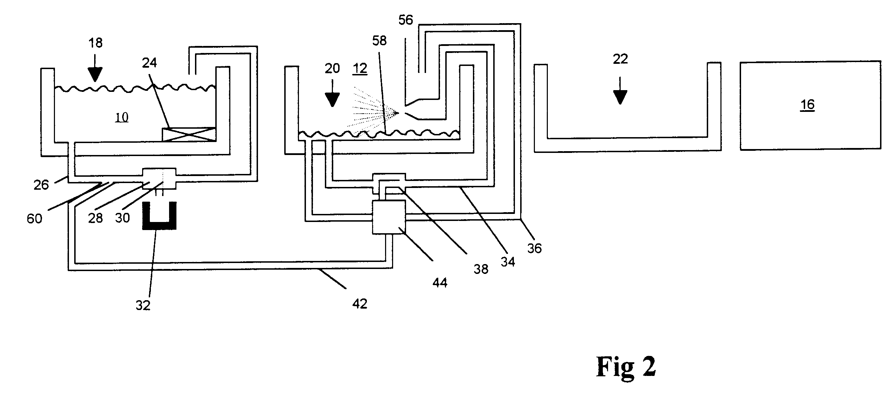

In einer weiteren Ausgestaltung der Erfindung in Figur 2 ist vorgesehen, daß der Kreislauf 34, der mit dem oben genannten hohen Durchsatz arbeitet, an seiner Austrittsstelle eine Düse 56 aufweist, aus der die Spülflüssigkeit austritt. Die zu reinigenden Gegenstände können hier abgesprüht werden, was zu einer hohen Spülwirkung führt. Zugleich ist die Menge des benötigten Spülbades deutlich geringer, was durch den Flüssigkeitsspiegel 58 angedeutet ist. Damit ist die Menge des im Vakuumverdampfer 44 zur Trennung zu verdampfenden Wasser deutlich weniger, nur etwa 10 bis 20 % der Menge nach der Ausführungsform in Figur 1, so daß die Trennung von Reinigungsflüssigkeit und Spülflüssigkeit mit sehr viel geringerem Aufwand zu bewerkstelligen ist.

In einer dritten Ausführung ist vorgesehen, daß durch Membrantechnik auch aus dem Reinigungsbad ein Teil der verschleppten Spülflüssigkeit, die dort in niedriger Konzentration als unerwünschter Anteil in dem aus dem Spülbad rückgewonnenen Reinigungsmittel enthalten ist, zurückgewonnen wird. Der Inhalt des ersten Bades wird im Kreislauf 26 über eine weitere Membran 46 geführt, um auf der Rückseite der Membran die Konzentration der Spülflüssigkeit zu erhöhen. Diese Membran 46 ist semipermeabel und im vorliegenden Anwendungsfall durchlässig für Wasser, nicht aber für die Reinigungsflüssigkeit, bestehend aus einem Glykoläthergemisch. Hinter dieser Membran 26 wird in einem Transportkreislauf 48 eine Flüssigkeit geführt, die wasserunlöslich ist, z.B. Silikon oder Mineralöl. Dieser Kreislauf sorgt für den Abtransport des Wassers, so daß keine zu hohen Wasserkonzentrationen hinter der Membran 46 entstehen, so daß das Wasser weiter abgezogen wird.

Da diese Transportflüssigkeit in dem Kreislauf 48 sich mit dem Wasser nicht mischt, kann das Wasser dann in einem Dekantierer, schematisch dargestellt mit dem Bezugszeichen 50, abgelassen werden und in einem Behälter 52 aufgefangen werden, von dem aus es über eine Leitung 54 weitertransportiert wird und in einem Ausfluß in das Bad 12, hier bestehend aus Wasser, zurückgeführt wird.

Wichtig für das beschriebene Verfahren ist, daß es dadurch ermöglicht wird, alle verschleppte Reinigungsflüssigkeit zurückzugewinnen und somit einen Prozeß darzustellen, in dem weder Spülflüssigkeit, hier Wasser, erneuert werden muß noch Reinigungsmittel, hier Glykoläther, in die Umwelt abgegeben werden. Auch verunreinigtes Wasser gelangt nicht aus dem Kreislauf heraus und muß nicht entsorgt werden. Somit ist der Prozeß sowohl ökologisch als auch wirtschaftlich vorteilhaft.

## Patentansprüche

1. Verfahren zum Reinigen von Gegenständen, wobei ein erster Reinigungsbehälter (18) Reinigungsflüssigkeit (10) in hoher Konzentration enthält, in die die zu reinigenden Gegenstände eingebracht werden,
ein erster Spülbehälter (20), in den die zu reinigenden Gegenstände nach ihrem Verbleib in der Reinigungsflüssigkeit eingebracht werden, wäßriges Spülbad (12) mit Anteilen von verschleppter Reinigungsflüssigkeit (10) in niedrigerer Konzentration enthält,
das Spülbad (12) mit den gelösten Anteilen der Reinigungsflüssigkeit (10) in niedriger Konzentration in einem ersten Kreislauf (36) umgewälzt wird,
in diesem ersten Umwälzkreislauf (36) eine Trenneinrichtung (44) vorgesehen ist, mit der die verschleppte Reinigungsflüssigkeit (10) von der Spülflüssigkeit (12) getrennt wird, und
diese in der Trenneinrichtung (44) gewonnene Reinigungsflüssigkeit (10) in den Reinigungsbehälter (18) zurückgeführt wird,
dadurch gekennzeichnet, daß
die Reinigungsflüssigkeit ein organisches, nichtwäßriges Lösungsmittel ist, in dem die Verunreinigungen der zu reinigenden Gegenstände in Lösung übergehen,
dem Reinigungsbehälter (18) ein zweiter Kreislauf (26) zugeordnet ist, in dem die Reinigungsflüssigkeit (10) im Reinigungsbehälter (18) umgewälzt wird,
in diesem zweiten Kreislauf (26) eine semipermeable Membran (30) für die Mikrofiltration des Reinigungsmittels zur Separierung der gelösten Verunreinigungen aus dem Reinigungsmittel vorgesehen ist, und
die Verunreinigungen zur Entsorgung (32) abgeführt werden.

2. Verfahren nach Anspruch 1, dadurch gekennzeichnet, daß der Siedepunkt der einen Flüssigkeit, vorzugsweise der der Spülflüssigkeit (12), niedriger ist als der Siedepunkt der anderen Flüssigkeit, vorzugsweise der der Reinigungsflüssigkeit (10),
die Trenneinrichtung in dem ersten Umwälzkreislauf einen Verdampfer (44) enthält,
und die durch den Verdampfungsprozeß rückgewonnene Reinigungsflüssigkeit in den Reinigungsmittelbehälter (12) zurückgeführt wird.

3. Verfahren nach Anspruch 2, dadurch gekennzeichnet, daß der Verdampfer ein Vakuumverdamfer (44) ist, dem Spülbehälter (20) ein dritter Kreislauf (34) zugeordnet ist, der die Spülflüssigkeit (12) umwälzt, und daß in diesem dritten Kreislauf (34) eine Wasserstrahlpumpe (38) angeordnet ist, die den Unterdruck für den dem ersten Kreislauf (36) zugeordneten Vakuumverdampfer (44) liefert.

4. Verfahren nach einem der Ansprüche 1 bis 3, dadurch gekennzeichnet, daß die im Verdampfer (44) zurückgewonnene Reinigungsflüssigkeit (10) in den zweiten Kreislauf (26) stromaufwärts der Membran (30) eingespeist wird.

5. Verfahren nach einem der Ansprüche 1 bis 4, dadurch gekennzeichnet, daß die Reinigungsflüssigkeit (10) in dem Reinigungsbehälter (18) erwärmt wird, und die Abwärme abgeleitet wird zur Unterstützung der Verdampfung im Vakuumverdampfer (44) des ersten Kreislaufs (36) des Spülbehälters (20).

6. Verfahren nach Anspruch 5, dadurch gekennzeichnet, daß dem Reinigungsbehälter (18) ein Ultraschallgeber (24) zugeordnet ist, der im Betrieb zugleich die Reinigungsflüssigkeit (10) des Reinigungsbehälters (18) erwärmt.

7. Verfahren nach einem der vorhergehenden Ansprüche, dadurch gekennzeichnet, daß als Membran eine Keramikmembran (30) eingesetzt wird.

8. Verfahren nach einem der Ansprüche 1 bis 6, dadurch gekennzeichnet, daß als Membran eine Polyäthylenfolie oder eine Polyamidfolie verwendet wird.

9. Verfahren nach einem der Ansprüche 1 bis 8, dadurch gekennzeichnet, daß die Spülflüssigkeit (12) im Spülbehälter (20) bei Umwälzung im dritten Kreislauf (34) durch eine Sprühdüse (44) austritt und der Sprühstrahl zur Spülung eingesetzt wird.

10. Verfahren nach einem der Ansprüche 1 bis 9, dadurch gekennzeichnet, daß eine Spülflüssigkeitsmembran (46) zur Abtrennung von Spülflüssigkeitsverunreinigungen aus dem Reinigungsbad (10) dient,
der Abtransport der Spülflüssigkeit hinter der Membran (46) durch eine Transportflüssigkeit erfolgt, in der die Spülflüssigkeit nicht lösbar ist,
die Spülflüssigkeit von der Transportflüssigkeit getrennt wird, und
die abgetrennte Spülflüssigkeit in den zweiten Behälter (20) zurückgeführt wird.

11. Verfahren nach Anspruch 10, dadurch gekennzeichnet, daß die Transportflüssigkeit ein Mineralöl oder Silikon ist.

12. Verwendung des Verfahrens nach einem der Ansprüche 1 bis 11 zur Verwirklichung eines geschlossenen Kreislaufs in einer Reinigungsanlage für mit Lötrückständen und/oder Flußmitteln verunreinigten Leiterplatten, die in dem ersten Behälter mit einer organischen Reinigungsflüssigkeit, vorzugsweise einem Gemisch aus Glykoläthern, gereinigt werden und anschließend in dem zweiten Behälter mit Wasser von der Reinigungsflüssigkeit gesäubert werden.
